# EUROPÄISCHE PATENTSCHRIFT

(11) **EP 0 576 857 B1**
(45) Veröffentlichungstag und Bekanntmachung des Hinweises auf die Patenterteilung: **06.09.1995**
(21) Anmeldenummer: 93108946.0
(22) Anmeldetag: 03.06.1993
(51) Int. Cl.: H05K 7/14, H01R 13/645

(54) **Codiereinrichtung für elektrische Baugruppen**
Coding means for electrical devices
Dipositif de codage pour installations électriques

(30) Priorität: 29.06.1992 DE 9208701 U
(43) Veröffentlichungstag der Anmeldung: 05.01.1994
(73) Patentinhaber: SIEMENS AKTIENGESELLSCHAFT, 80333 München (DE)
(72) Erfinder: Zell, Karl, Dipl.-Ing., D-8134 Niederpöcking (DE); Seibold, Jürgen, Dipl.-Ing., D-8021 Baierbrunn (DE); Seidel, Peter, D-8038 Gröbenzell (DE)

(56) Entgegenhaltungen:
- EP-A- 0 179 999
- EP-A- 0 199 029
- EP-A- 0 239 785
- US-A- 3 611 272
- US-A- 3 714 617
- US-A- 4 568 134
- US-A- 5 066 250

## Beschreibung

Die Erfindung betrifft eine Codiereinrichtung für elektrische Baugruppen, die parallel zueinander in einen Baugruppenrahmen einschiebbar sind und über rückwärtig angebrachte Steckvorrichtungen mit einer Rückwandverdrahtungsplatte kontaktiert sind.

Es ist z.B. aus der EP-A-0 179 999 bekannt, die Codierungen an einer Längsseite des Baugruppensteckers anzubringen. Hierdurch kann allerdings die vorgegebene Teilungsbreite überschritten werden. Für den Fall, daß die Teilungsbreite nicht überschritten werden darf, ist es z.B. aus der EP-B-0 239 785 bekannt, die Codierung in den Stecker zu integrieren. Dies führt aber zu Verlusten hinsichtlich der Anzahl der möglichen Kontaktübergänge. Auch war die Möglichkeit der Codierung auf den Befestigungsflanken allgemein bekannt (s. z.B. EP-C-0 199 029).

Elektrische Baugruppen sollen im Baugruppenrahmen codiert werden, wobei die Codierung nicht zu einem Überschreiten der kleinsten Einbauteilung von 15 mm führen soll. Weiter soll die Codierung nicht zu einer Änderung an Rahmenteilen, wie Führungsschienen und Rückwandverdrahtungsplatten, führen. Das heißt es sollen die Rahmenbedingungen der Norm IEC48D (Sec) 44 nicht verändert werden.

Diese Aufgabe wird für eine Codiereinrichtung der obengenannten Art dadurch gelöst, daß zwischen den Führungsschienen auf der Rückwandverdrahtungsplatte ein Codierflansch mit drei im rechten Winkel zueinander angeordneten quadratischen Öffnungen angeordnet ist, daß auf der Baugruppe neben dem Steckverbinder ein entsprechendes, ebenfalls mit drei im rechten Winkel zueinander angeordneten quadratischen Öffnungen versehenes Codiergehäuse angeordnet ist, und daß in die Öffnungen Codierstifte durch 90°-Drehungen unterschiedlich einrastbar sind, deren freie Enden als Zungen mit rechteckigem Querschnitt ausgebildet sind, wobei die Fläche des Querschnitts der Zungen der halben Fläche des Querschnitts der quadratischen Öffnungen entspricht.

Bei der erfindungsgemäßen Codiereinrichtung wird der Raum zwischen Führungsschiene und Steckverbinder sowie zwischen den Führungsschienen in der kleinstmöglichen Teilung von 15 mm zur Unterbringung einer Codierung genutzt. Die Codierung besteht aus einem Codierstift, einem Codiergehäuse auf der Baugruppe und einem Codierflansch auf der Rückwandverdrahtungsplatte. Die vorgegebene Fläche ermöglicht die Unterbringung von drei Codierplätzen, in denen der Codierstift durch 90°-Drehungen unterschiedlich eingerastet werden kann. Bei der erfindungsgemäßen Codiereinrichtung sind keine Änderungen an Rahmenteilen, wie Führungsschienen und Rückwandverdrahtungsplatten notwendig.

Weitere Vorteile der vorliegenden Erfindung ergeben sich aus den Unteransprüchen sowie aus der nachfolgenden Beschreibung anhand eines in der Zeichnung dargestellten Ausführungsbeispiels der erfindungsgemäßen Codiereinrichtung.

Es zeigen
- FIG 1: eine Draufsicht und
- FIG 2: eine Seitenansicht eines Codierflansches,
- FIG 3: eine Draufsicht und
- FIG 4: eine Seitenansicht eines Codiergehäuses,
- FIG 5: eine Draufsicht und
- FIG 6: eine Seitenansicht eines Codierstiftes,
- FIG 7: einen teilweisen Schnitt durch eine eingeschobene Baugruppe, und
- FIG 8: schematisch die Codierung einer Codiereinrichtung gemäß der vorliegenden Erfindung.

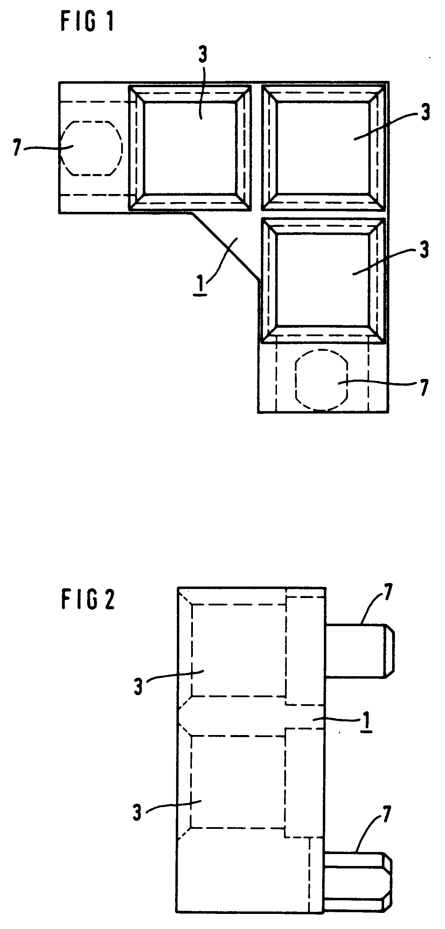

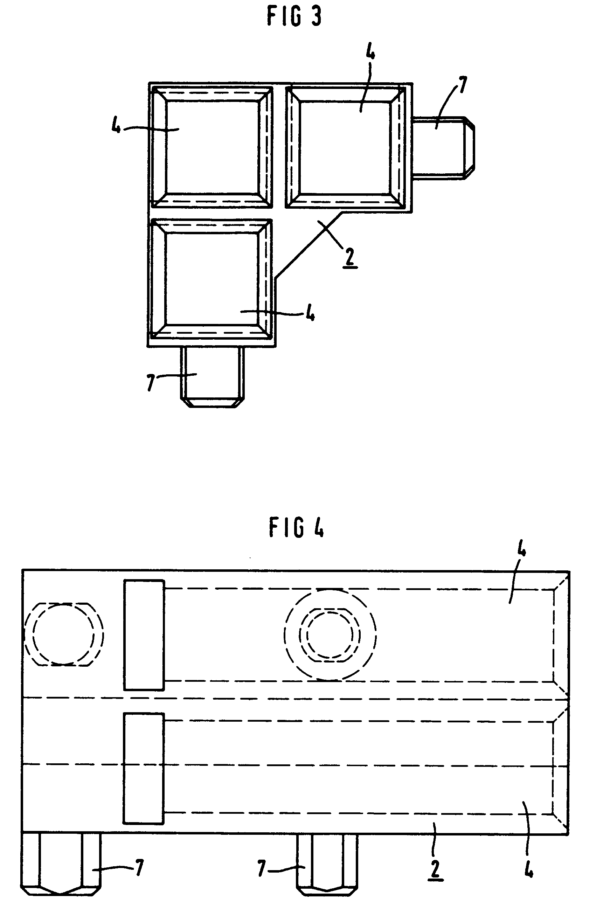

FIG 1 und FIG 3 zeigen den Aufbau eines Codierflansches zur Anbringung auf einer Rückwandleiterplatte. Der Codierflansch 1 besteht aus den drei im rechten Winkel zueinander angeordneten Öffnungen 3 des Codierflansches 1. In der FIG 2 ist zu erkennen, daß sich die Öffnungen in ihrem unteren Bereich erweitern, so daß ein Codierstift 5 einrastbar ist, wie später noch gezeigt wird. Jeder Codierflansch ist mit zwei Einpreßzapfen 7 versehen, mit welchen er auf der Rückwandleiterplatte befestigt werden kann.

FIG 3 und FIG 4 zeigen ein Codiergehäuse gemäß der vorliegenden Erfindung. Dieses Codiergehäuse weist auch im wesentlichen drei im rechten Winkel zueinanderliegende Öffnungen 4 des Codiergehäuses 2 auf. Die Öffnungen 4 des Codiergehäuses 2 weisen ebenso wie die Öffnungen 3 des Codierflansches 1 einen quadratischen Querschnitt auf. Weiterhin weist das Codiergehäuse 7 mehrere Einpreßzapfen 7 auf, mit denen es auf der Baugruppe befestigt werden kann. Aus der FIG 4 ist zu entnehmen, daß die Öffnungen 4 des Codiergehäuses 2 tiefer sind als die Öffnungen 3 des Codierflansches. Der Grund wird später näher beschrieben.

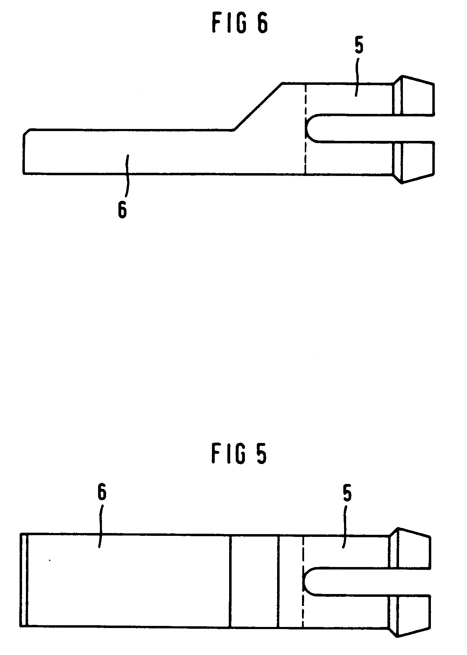

FIG 5 und FIG 6 zeigen den Aufbau eines Codierstiftes. Den FIGUREN ist zu entnehmen, daß die Codierstifte 5 an ihrem unteren Ende vier federnde, hier nicht näher bezeichnete Rastnasen aufweisen, mit denen sie jeweils in den Öffnungen gehalten werden. Die vorderen Enden der Codierstifte 5 sind als Zungen 6 ausgebildet, wobei die Querschnittsfläche der rechteckförmigen Zungen halb so groß ist wie die Querschnittsfläche der Öffnungen.

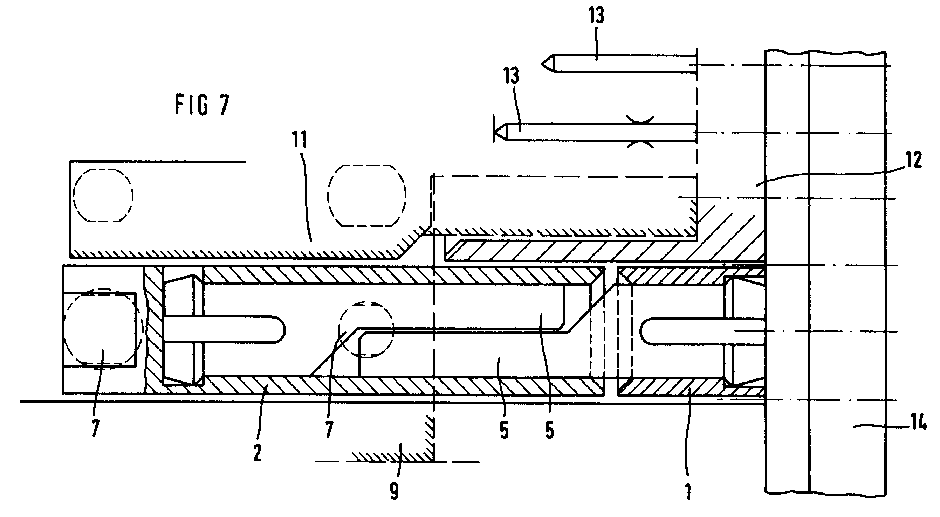

FIG 7 zeigt nun einen teilweisen Schnitt durch eine eingeschobene Baugruppe und damit gleichzeitig durch einen Teil der erfindungsgemäßen Codiereinrichtung. In der FIG 7 ist der Codierflansch 1 sowie das Codiergehäuse 2 zu erkennen, wobei der Codierflansch auf der Rückwandleiterplatte 14 befestigt ist, während das Codiergehäuse 2 auf der Baugruppe mit der Baugruppenleiterplatte 9 befestigt ist. Neben dem Codiergehäuse 2 ist die Baugruppenfederleiste 11 der Steckverbindung angedeutet. Weiterhin ist neben der Codiervorrichtung die Zentrierleiste 12, die auf die Kontaktmesser 13 der Rückwandleiterplatte 14 aufgeschoben ist, angedeutet. Im wesentlichen soll in dieser FIGUR die Verrastung der Codierstifte in den Öffnungen 3 und 4, sowie das Ineinandergreifen der Codierstifte 5 gezeigt werden. Dies ist aus der FIGUR eindeutig zu erkennen. Die Öffnungen 4 der Codiergehäuse 2 sind so bemessen, daß sie die eingerasteten Codierstifte 5 völlig umschließen. Damit soll bei der Handhabung der Baugruppe ein Schutz der Codierstifte erreicht werden. Auf der Rückwand ist die Tiefe der Öffnungen 3 der Codierflansche 1 so bemessen, daß die Codierstifte 5 dagegen freistehen. Damit soll erreicht werden, daß diese Codierstifte 5 bei einer Umcodierung bzw. Falschcodierung ohne Zerlegung des Baugruppenrahmens leicht zu greifen sind und leicht ausgetauscht werden können.

Die Länge der Codierstifte ist so bemessen, daß die Baugruppenfederleiste 11 auf der Baugruppe bereits in die Zentrierleiste 12 eingetaucht ist, wenn die Codierstifte 5 aufeinandertreffen.

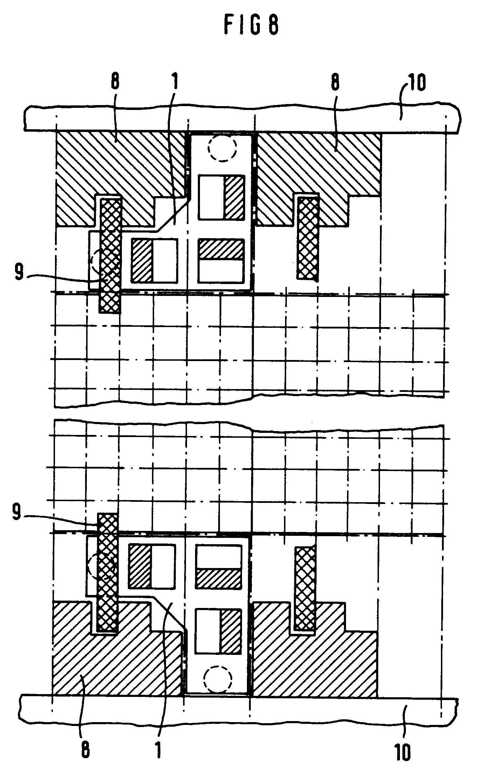

FIG 8 zeigt schematisch die Codierung einer Codiereinrichtung gemäß der vorliegenden Erfindung. In dieser FIGUR sind mit 10 Teile von oberen und unteren Baugruppenrahmen angedeutet, an welchen die Führungsschienen 8 für die Baugruppenleiterplatten 9 befestigt sind. Aus dieser FIGUR ergibt sich auch die Anbringung der Codierflansche 1 auf der Rückwandleiterplatte. Wie aus dieser FIGUR leicht zu erkennen ist, ergeben sich für jede Codieröffnung durch 90°-Drehungen der Codierstifte vier verschiedene Einsetzmöglichkeiten. Damit ergeben sich, wenn man sowohl oben als auch unten die gleiche Codierung wählt, wie in FIG 8 gezeigt, 4 x 4 x 4 = 64 unterschiedliche Codiermöglichkeiten. Wählt man nun dagegen oben und unten ungleiche Codierungen, so ergeben sich insgesamt 4096 Codiermöglichkeiten.

## Patentansprüche

1. Codiereinrichtung für elektrische Baugruppen, die parallel zueinander in einen Baugruppenrahmen einschiebbar sind und über rückwärtig angebrachte Steckvorrichtungen mit einer Rückwandverdrahtungsplatte kontaktiert sind,
**dadurch gekennzeichnet**,
daß zwischen den Führungsschienen (8) auf der Rückwandverdrahtungsplatte (14) ein Codierflansch (1) mit drei im rechten Winkel zueinander angeordneten quadratischen Öffnungen (3) angeordnet ist, daß auf der Baugruppe neben dem Steckverbinder ein entsprechendes, ebenfalls mit drei im rechten Winkel zueinander angeordneten quadratischen Öffnungen (4) versehenes Codiergehäuse angeordnet ist, und daß in die Öffnungen (3, 4) Codierstifte (5) durch 90°-Drehungen unterschiedlich einrastbar sind, deren freie Enden als Zungen mit rechteckförmigem Querschnitt ausgebildet sind, wobei die Fläche des Querschnitts der Zungen (6) der halben Fläche des Querschnitts der quadratischen Öffnungen (3, 4) entspricht.

2. Codiereinrichtung nach Anspruch 1,
**dadurch gekennzeichnet**,
daß sowohl für die Codiergehäuse (2) als auch für die Codierflansche (1) nur ein Codierstift-Typ (5) Verwendung findet.

3. Codiereinrichtung nach Anspruch 1 oder 2,
**dadurch gekennzeichnet**,
daß die Öffnungen im Codiergehäuse (2) so tief sind, daß die Codierstifte (5) völlig umschlossen sind.

4. Codiereinrichtung nach Anspruch 1 oder 2,
**dadurch gekennzeichnet**,
daß die Tiefe der Öffnungen im Codierflansch (1) so bemessen ist, daß die Zungen (6) der Codierstifte (5) nicht umschlossen sind.

5. Codiereinrichtung nach Anspruch 1,
**dadurch gekennzeichnet**,
daß die Codierflansche (1) sowie die Codiergehäuse (2) mit Einpreßzapfen (7) versehen sind.

## Claims

1. Coding device for electrical assemblies which can be inserted parallel to one another into a mounting rack and which make contact with a wiring back plane via plug facilities fitted to the rear, characterized in that a coding flange (1) having three square openings (3) arranged at right angles to each other is arranged between the guide rails (8) and the wiring back plane (14), in that a corresponding coding housing, which is likewise provided with three square openings (4) arranged at right angles to each other, is arranged on the as-sembly adjacent to the plug connector, and in that coding pins (5), whose free ends are designed as tongues having a rectangular cross-section, the area of the cross-section of the tongues (6) corresponding to half the area of the cross-section of the square openings (3, 4), can be locked into the openings (3, 4) by rotation through 90° in different manners.

2. Coding device according to Claim 1, characterized in that only one type (5) of coding pin is used both for the coding housing (2) and for the coding flanges (1).

3. Coding device according to Claim 1 or 2, characterized in that the openings in the coding housing (2) have such a depth that the coding pins (5) are completely enclosed.

4. Coding device according to Claim 1 or 2, characterized in that the depth of the openings in the coding flange (1) is dimensioned such that the tongues (6) of the coding pins (5) are not enclosed.

5. Coding device according to Claim 1, characterized in that the coding flanges (1) as well as the coding housings (2) are provided with press-in pegs (7).

## Revendications

1. Dispositif de codage pour des modules électriques pouvant être insérés parallèlement les uns par rapport aux autres dans un cadre de modules, et qui sont reliés à une plaque de câblage de paroi arrière par des dispositifs à enfichage disposés à l'arrière,
caractérisé par le fait qu'une bride de codage (1) est disposée entre les rails de guidage (8) sur la plaque de câblage (14) de paroi arrière, laquelle comporte trois ouvertures carrées (3) disposées à angle droit les unes par rapport aux autres, que, outre le connecteur enfichable, un boîtier de codage correspondant, qui comporte également trois ouvertures carrées (4) disposées à angle droit les unes par rapport aux autres, est disposé sur le module et que des broches de codage (5), dont les extrémités libres sont formées de languettes ayant une section transversale de forme rectangulaire, peuvent être encliquetées de différentes manières dans les ouvertures (3, 4) par des rotations à 90°, la surface de la section transversale des languettes (6) correspondant à la moitié de la surface de la section transversale des ouvertures carrées (3, 4).

2. Dispositif de codage selon la revendication 1,
caractérisé par le fait que, autant pour les boîtiers de codage (2) que pour les brides de codage (1), on n'utilise qu'un seul type de broches de codage (5).

3. Dispositif de codage selon l'une des revendications 1 ou 2,
caractérisé par le fait que la profondeur des ouvertures pratiquées dans le boîtier de codage (2) est telle que les broches de codage (5) sont complètement entourées.

4. Dispositif de codage selon l'une des revendications 1 ou 2,
caractérisé par le fait que la profondeur des ouvertures pratiquées dans la bride de codage (1) est dimensionnée, de telle sorte que les languettes (6) des broches de codage (5) ne soient pas entourées.

5. Dispositif de codage selon la revendication 1,
caractérisé par le fait que les brides de codage (1) ainsi que les boîtiers de codage (2) sont munis de tenons d'enfoncement (7).
